# EUROPÄISCHE PATENTSCHRIFT

(11) **EP 0 770 275 B1**
(45) Veröffentlichungstag und Bekanntmachung des Hinweises auf die Patenterteilung: **18.08.1999**
(21) Anmeldenummer: 96907494.7
(22) Anmeldetag: 18.03.1996
(51) Int. Cl.: H01S 3/0941

(54) **DIODENGEPUMPTER HOCHLEISTUNGSFESTKÖRPERLASER**
DIODE-PUMPED HIGH-POWERED SOLID STATE LASER
LASER A SOLIDE DE HAUTE PUISSANCE A POMPAGE PAR DIODES

(30) Priorität: 28.04.1995 DE 19515635
(43) Veröffentlichungstag der Anmeldung: 02.05.1997
(73) Patentinhaber: JENOPTIK Aktiengesellschaft, 07739 Jena (DE)
(72) Erfinder: KRÄNERT, Jürgen, D-07743 Jena (DE); KÜHN, Holger, D-07747 Jena (DE); MÜLLER, Holger, D-07747 Jena (DE); KUFERT, Siegfried, D-07768 Kahla (DE)
(74) Vertreter: Geyer, Werner, Dr.-Ing.
(86) Internationale Anmeldenummer: EP9601151
(87) Internationale Veröffentlichungsnummer: WO9634435

(56) Entgegenhaltungen:
- FR-A- 2 675 960
- APPLIED OPTICS, 20 SEPT. 1994, USA, Bd. 33, Nr. 27, ISSN 0003-6935, Seiten 6377-6382, XP000469288 COMASKEY B ET AL: "24-W average power at 0.537 mu m from an externally frequency-doubled Q-switched diode-pumped Nd:YOS laser oscillator"
- IEEE JOURNAL OF QUANTUM ELECTRONICS, APRIL 1992, USA, Bd. 28, Nr. 4, ISSN 0018-9197, Seiten 992-996, XP000272690 COMASKEY B J ET AL: "High average powers diode pumped slab laser"

## Beschreibung

Die Erfindung betrifft einen diodengepumpten Hochleistungsfestkörperlaser gemäß dem Oberbegriff des Patentanspruchs 1.
Eine derartige Anordnung ist im weitesten Sinne aus der US PS 4,945,544 bekannt.

Festkörperlaser werden im allgemeinen durch die Zufuhr optischer Energie zur Lasertätigkeit angeregt ("optisches Pumpen"). Die Quelle dieser Energie sind dabei konventionelle Krypton- oder Xenonlampen, neuerdings auch im nahen Infrarotbereich emittierende Halbleiterdioden.
Halbleiterlaser sind dabei nahezu ideale Lichtquellen für die optische Anregung von Festkörperlasern. Sie zeichnen sich im Vergleich gegenüber konventionellen Lampen insbesondere durch eine gute spektrale Anpassung der Pumpstrahlung an die Absorptionsbanden des laseraktiven Kristalls sowie eine hohe Lebensdauer aus und ermöglichen die Entwicklung von kompakten, nur aus Festkörpermaterialien aufgebauten, effizienten Lasersystemen, die sich durch geringe Abmessungen und hohe Wirkungsgrade auszeichnen. Stand der Technik sind heute das sogenannte longitudinale und transversale Pumpen von im allgemeinen zylindrischen Medien. Die effizientesten Lasersysteme lassen sich mit der longitudinalen Pumpgeometrie verwirklichen. So lassen sich bei guter Anpassung der Laserdioden-Strahlung auf eine Absorptionsbande des Festkörperlasermaterials Systeme entwickeln, bei denen das Verhältnis zwischen optischer Pumpleistung und optischer Ausgangsleistung größer 50% erreicht. Die Ausgangsleistung dieser Systeme wird dadurch limitiert, daß einerseits keine Halbleiterlaser mit genügend hoher Ausgangsleistung zur Verfügung stehen, die gleichzeitig eine kleine, emittierende Apertur besitzen und andererseits die thermische Belastbarkeit der Laserdiodenkristalle begrenzt ist. Höhere Ausgangsleistungen sind nur mit transversaler Pumpgeometrie realisierbar, die es erlaubt, das Licht einer Vielzahl von Laserdioden oder Laserdiodenarrays in das Lasermedium einzukoppeln. Derartig konzipierte Anordnungen lassen sich grundsätzlich in direkte transversale und indirekte transversale Anordnungen unterscheiden. Direkte transversale Anordnungen haben durch die direkte Einstrahlung in das Lasermedium den Vorteil einer hocheffizienten, verlustarmen Pumplichttransmission in das Lasermedium mit vergleichsweise geringem Justageaufwand. Der Anzahl der um das Lasermedium anordenbaren Laserdiodenarrays und der Minimierung des Querschnitts des Lasermediums sind enge Grenzen gesetzt, da die Dioden auf Grund ihrer hohen Divergenz möglichst nah vor dem Lasermedium angeordnet werden müssen.
Bei indirekten transversalen Anordnungen werden die stark divergenten Strahlenbündel der Emissionsstrahlung über eine Koppeloptik in parallele oder konvergente Strahlenbündel umgeformt. Der Abstand zum Lasermedium kann damit größer gewählt werden. Auf Grund des Raumgewinns lassen sich eine weitaus höhere Anzahl von Diodenarrays um das Lasermedium anordnen. Neben hohen Justageaufwänden und damit auftretenden Stabilitätsproblemen ist auch die Kompaktheit solcher Anordnungen vermindert.
Zur Erlangung eines Hochleistungslasers mit hoher Effizienz und gutem Strahlprodukt müssen mehrere Anforderungen erfüllt sein. Die Erfüllung dieser Anforderungen erfolgt mit den aus dem Stand der Technik bekannten Lösungen auf unterschiedliche Weise und in unterschiedlichem Maße. Letztendlich stellt jede Lösung eine Kompromißlösung dar, da sich die Anforderungen einerseits teilweise entgegenstehen und natürlich andererseits die permanente Forderung nach langzeitstabilen wartungsfreien Systemen mit geringem konstruktiven und technologischen Aufwand steht.
Eine Hauptforderung ergibt sich aus der Temperaturabhängigkeit (ca. 0,25 nm/°C) der Laserdioden, auf Grund derer die Emissionswellenlänge präzise auf eine Absorptionsbande des Festkörperlasermaterials abgestimmt werden kann. Die extrem schmale Halbwertsbreite der Anregungsbande von im allgemeinen < 1 nm erfordert zwangsläufig eine notwendige Temperaturstabilisierung. Umfaßt die Pumpanordnung mehrere Diodenarrays, so müssen diese, da sie herstellungsbedingt in ihrer Emissionswellenlänge variieren, einzeln temperaturstabilisiert werden, um sie alle genau auf die Absorptionsbande abzustimmen. Die Vielzahl von notwendigen Zu- und Abführungen für das Kühlmittel machen derartige Anordnungen aufwendig und störanfälliger, so daß man in der Regel eine gewisse Wellenlängendrift zwischen den Emissionswellenlängen in Kauf nimmt und alle in einer Ebene anzuordnenden Laserdiodenarrays auf einen gemeinsamen Kühlkörper montiert. Derartige Anordnungen sind z.B. aus US-PS 4,719,631, US-PS 5,084,886 und DE 39 14 492 A1 bekannt. Über den sich daraus ergebenden Nachteil, nämlich, daß mit der Drift der Emissionswellenlänge aus der Absorptionsbande des Lasermediums der erforderliche Absorptionsweg exponentiell anwächst, schweigen die Verfasser dieser Schriften. Praktisch bedeutet das für Lösungen, bei denen die Absorption mit dem einmaligen Durchlaufen des Lasermediums erfolgen soll, daß entweder hohe Energieverluste in Kauf genommen werden müssen oder der Durchmesser des Lasermediums derart vergrößert wird, daß auch noch die Emissionswellenlänge mit größer Drift, die den längsten Absorptionsweg benötigt, vollständig absorbiert wird. Letztere Maßnahme steht jedoch einer zweiten Anforderung zur Erlangung einer guten Inversion und damit Effektivität des Lasers entgegen. Sie besteht darin, das angeregte Volumen möglichst gering zu halten, um eine hohe Energiedichte zu erzielen.
In der US-PS 4,945,544 wird das indirekte transversale Pumpen eines Laserstabes mit Laserdioden an sich beansprucht. Mehreren, auf einer Parallelen zur Achse des Laserstabes angeordneten Laserdioden, ist eine Zylinderlinse derart vorgeordnet, daß die Emissionsstrahlung der Laserdioden auf die Achse des Laserstabes fokussiert wird. Hier wird, ungeachtet der Temperaturabhängigkeit, davon ausgegangen, daß alle Dioden die gleiche mit der Absorptionsbande des Lasermediums übereinstimmende Wellenlänge emittieren, was praktisch nicht zutrifft. Unabhängig davon wird zwar eine hohe Energiedichte im Bereich der Achse des Laserstabes erzielt, jedoch wird die letztendlich dritte Anforderung für eine hohe Effizienz, eine möglichst homogene Verteilung der Energiedichte im Lasermedium, nicht erfüllt. Dieses trifft auch für die in der US-PS 4,756,002 offenbarten Lösung zu. Zugunsten einer weniger aufwendigen Temperaturstabilisierung durchläuft die Pumpstrahlung mittels Mehrfachreflexion mehrmals das Lasermedium, um den möglichen Weg zur Absorption zu verlängern und somit eine vollständige Absorption zu erreichen. Es entstehen zwangsläufig im Lasermedium Bereiche sehr unterschiedlicher Energiedichte. Über den zunehmenden Justageaufwand bei wachsender Anzahl von um und längs des Lasermediums angeordneten Laserdiodenarrays werden im Stand der Technik keine Überlegungen angestellt.

Der Erfindung liegt die Aufgabe zugrunde, einen diodengepumpten Hochleistungsfestkörperlaser zu entwickeln, der sich durch Kompaktheit und hohe Effizienz auszeichnet.
Diese Aufgabe wird durch die in Anspruch 1 beschriebene Erfindung gelöst. Vorteilhafte Weiterbildungen der Erfindung sind in den Unteransprüchen beschrieben.
Der Grundgedanke der Erfindung besteht darin, daß die Weglänge der jeweils von einem Laserdiodenarray emittierten Strahlung durch den Festkörperlaserstab und der erforderliche Absorptionsweg für diese Strahlung, bestimmt durch die Emissionswellenlänge dieser Strahlung und die Dotierung des laseraktiven Mediums, weitestgehend aufeinander abgestimmt werden. Dadurch wird eine höchstmögliche Absorption bei kleinstmöglichem Querschnitt des Laserstabes und damit hohe Energiedichte, die möglichst homogen verteilt ist, erreicht.
Zwingende Voraussetzung, um die erfindungsgemäße Abstimmung zu erlangen, ist die Auswahl und Anordnung der Laserdiodenarrays entsprechend ihrer Emissionswellenlänge bei gleicher Betriebstemperatur. Innerhalb eines Pumpmoduls werden die Laserdiodenarrays in der Reihenfolge abnehmender Emissionswellenlänge, bezogen auf die gleiche Betriebstemperatur, angeordnet, wobei zumindest das Laserdiodenarray mit der größten Wellenlänge auf die Temperatur stabilisiert wird, bei welcher die Emissionswellenlänge der Absorptionsbande des laseraktiven Mediums entspricht.
Die Temperaturstabilisierung der folgenden Laserdiodenarrays kann entweder z.B. durch Anordnung auf einem gemeinsamen Kühlkörper auf die gleiche Temperatur erfolgen oder vorteilhafterweise abgestuft werden auf geringfügig höhere Temperaturen, wodurch die Drift der Emissionswellenlänge der Strahlung der einzelnen Diodenarrays zur Absorptionsbande des laseraktiven Mediums und damit die Differenz des erforderlichen Absorptionsweges verringert wird. Die Absorptionswege können vorteilhafterweise für die Strahlung zunehmender Drift auch dadurch verringert werden, daß das aktive Lasermedium im Strahlungsbereich der Laserdiodenarrays mit Drift entsprechend höher dotiert wird.
Die erfindungsgemäße Abstimmung kann, ebenso wie durch die aufgezeigte Verringerung des Absorptionsweges, durch eine Variation der Weglänge der Strahlung der einzelnen Laserdiodenarrays durch den Festkörperlaserstab erfolgen. Unterschiedliche Weglängen können durch Querschnittsvariation des Laserstabes, der vorteilhafterweise konisch ausgebildet sein kann, erreicht werden, oder aber durch gezielt unterschiedliche Strahlablenkung, so daß die Strahlung mit größerem erforderlichen Absorptionsweg den Festkörperlaserstab im Zentralbereich durchdringt, während die Strahlung mit kürzerem erforderlichen Absorptionsweg, nämlich die ohne oder mit nur geringer Drift, auch die Randbereiche des Festkörperlaserstabs durchdringt, wodurch die mittlere Weglänge eines solchen Strahlenbündels geringer ist als die mittlere Weglänge eines den Festkörperlaserstab im Zentralbereich durchdringenden Strahlenbündels. Die Strahlablenkung der Strahlenbündel kann auch durch unterschiedliche Schnittweiten, einer unterschiedlichen Brechzahl im jeweils durchsetzten Bereich der Koppeloptik oder durch unterschiedliche Durchmesser der Koppeloptik in den durchsetzten Bereichen, z. B. durch Verwendung einer konischen Linse erfolgen. Statt einer Zylinder- oder konische Linse ist auch die Verwendung einer Gradientenlinse oder sogar die Verwendung einer diffraktiven Optik denkbar.

In einer vorteilhaften Ausführung des erfindungsgemäßen diodengepumpten Hochleistungsfestkörperlaser sind eine ungeradzahlige Anzahl von Laserdiodenarrays gleichmäßig verteilt um den Festkörperlaserstab angeordnet. Ein den Festkörperlaserstab umschließendes Kühlrohr ist jeweils in den, den Laserdiodenarrays gegenüberliegenden Bereichen, verspiegelt, so daß die beim ersten Durchdringen des Festkörperlaserstabes nicht vollständig absorbierte Strahlung zurückreflektiert wird, um ein zweites Mal in den Festkörperlaserstab einzudringen.

Die Erfindung wird im folgenden anhand der Zeichnung an einem Ausführungsbeispiel näher erläutert. Darin zeigen:

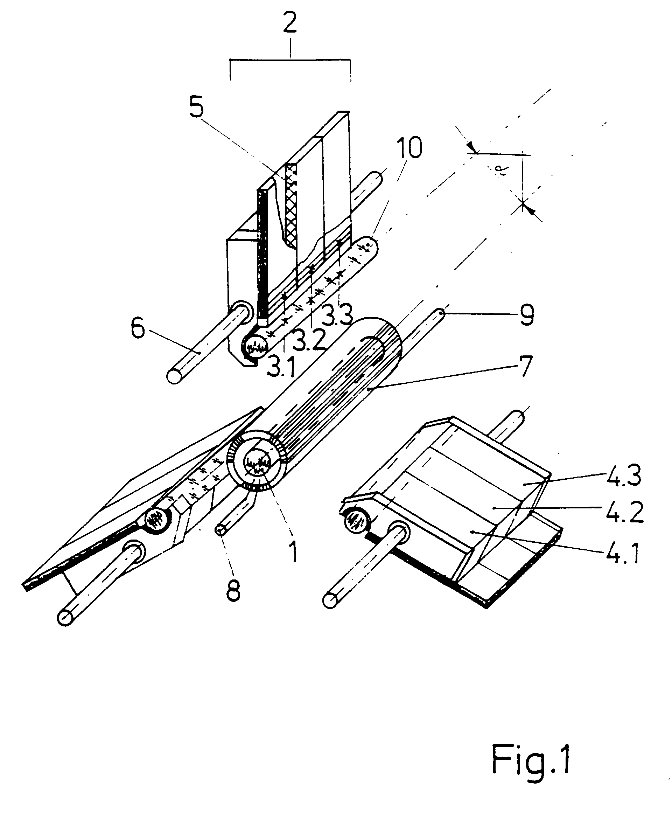

- Fig. 1: im Prinzip den Aufbau für einen erfindungsgemäßen diodengepumpten Hochleistungslaser mit drei Pumpmodulen als Explosivdarstellung

Bei dem in Fig. 1 dargestellten Ausführungsbeispiel sind um den Festkörperlaserstab 1, hier ein zylinderförmiger Nd:YAGstab mit gleichmäßiger Dotierung, drei Pumpmodule 2 angeordnet. Die Pumpmodule 2 sind identisch aufgebaut und umfassen je drei in Reihe parallel zur Achse des Festkörperlaserstabes 1 angeordnete Laserdiodenarrays 3.1; 3.2; 3.3, die jeweils auf einem Kühlkörper 4 angeordnet sind. Durch eine zwischen den Kühlkörpern 4.1 und 4.2 sowie 4.2 und 4.3 eingebrachte Isolierfolie 5 sind die Kühlkörper 4.1,; 4.2; 4.3 gegeneinander thermisch und elektrisch isoliert. Eine thermische Verbindung der Kühlkörper 4.1; 4.2; 4.3 untereinander besteht jeweils über ein durch die Kühlkörper 4.1; 4.2; 4.3, parallel zur Achse des Festkörperlaserstabes 1, geführtes Kühlrohr 6. Die Kühlmittelzuführung erfolgt seitens der Kühlkörper 4.1. Dadurch werden die Kühlkörper 4.1 am stärksten und die Kühlkörper 4.3, durch die zunehmende Erwärmung des Kühlmittels, am geringsten gekühlt. Es entsteht so eine geringfügige Temperaturdifferenz zwischen den Kühlkörpern 4.1 und 4.2 sowie 4.2 und 4.3 und damit eine geringfügige Differenz der Betriebstemperaturen der einzelnen Laserdiodenarrays 3.1; 3.2; 3.3. Die Kühlrohre 6 der drei Pumpmodule 2 sind eingangsseitig über eine nicht dargestellte erste Ausgleichskammer mit dem Kühlmitteleingang 8 eines den Festkörperlaserstab 1 umschließenden Kühlzylinders 7 und einer ebenfalls nicht dargestellten Kühlmittelzuführung verbunden, wodurch die einzelnen Pumpmodule 2 im Mittel auf die gleiche Temperatur gekühlt werden und ein Druckausgleich stattfindet. Ausgangsseitig sind die Kühlrohre 6 der drei Pumpmodule 2 über eine nicht dargestellte zweite Ausgleichskammer mit dem Kühlmittelausgang 9 des Kühlzylinders 7 und einer ebenfalls nicht dargestellten Kühlmittelabführung verbunden. Durch eine Vorauswahl sind sämtliche, für die Gesamtanordnung erforderlichen Laserdiodenarrays 3 so ausgewählt, daß ihre Emissionswellenlänge bei gleicher Betriebstemperatur möglichst gering voneinander abweicht.
Von den neun ausgewählten Laserdiodenarrays 3 sind die drei mit der größten Emissionswellenlänge jeweils eingangsseitig der Kühlrohre 6 angeordnet, so daß diese mit gleicher Temperatur gekühlt werden. Die Kühlmitteltemperatur ist so gewählt, daß diese drei Laserdiodenarrays 3.1 eine Emissionswellenlänge aufweisen, welche mit der Absorptionsbande des aktiven Lasermediums des Festkörperlaserstabes 1 übereinstimmt. Die Laserdiodenarrays 3.2 und 3.3 sind in der Reihenfolge abnehmender Wellenlänge und damit zunehmender Drift von der Absorptionsbande angeordnet. Durch die Kühlung in beschriebener Weise fällt die Drift geringer aus, als wenn die Laserdiodenarrays 3.2 und 3.3 auf die gleiche Temperatur gekühlt werden würden wie die Laserdiodenarrays 3.1. Bewirkt wird dadurch eine Verringerung der Differenz des für die Absorption der Strahlung der einzelnen Laserdiodenarrays erforderlichen Absorptionswege.
Ein weiterer Effekt zur Steigerung der Effizienz des Ausführungsbeispiels wird durch die erfindungsgemäße Anordnung von Koppeloptiken 10, hier Zylinderlinsen, erzielt. Die Achsen der Koppeloptiken 10 sind zur Achse des Festkörperlaserstabes 1 in Richtung zu den Pumpmodulen 2 hin um den Winkel α verkippt. Dadurch entsteht für die Laserdiodenarrays 3.1, 3.2 und 3.3 eine unterschiedliche Schnittweite S₁, S₂ und S₃, wobei S₁ > S₂ > S₃ ist. Die Strahlenbündel der Laserdiodenarrays 3.1, 3.2 und 3.3 nehmen daher nach unterschiedlicher Strahlformung durch die Koppeloptik 10 unterschiedliche Wege durch den Festkörperlaserstab 1. Die beim ersten Durchlaufen des Festkörperlaserstab 1 nicht absorbierte Strahlung trifft auf den Umfang des Kühlzylinders 7. Dieser ist in den, den Laserdiodenarrays 3 gegenüberliegenden Bereichen verspiegelt, so daß die nicht absorbierte Strahlung in den Festkörperlaserstab 1 zurückreflektiert wird.

## Patentansprüche

1. Diodengepumpter Hochleistungsfestkörperlaser mit einem Festkörperlaserstab (1), mindestens einem zur Achse des Festkörperlaserstabs (1) parallel angeordneten Pumpmodul (2), welcher mindestens zwei temperaturstabilisierte Laserdiodenarrays (3) umfaßt und je einer zwischen Pumpmodul (2) und Festkörperlaserstab (1) angeordneten Koppeloptik (10), dadurch gekennzeichnet,
daß die Laserdiodenarrays (3) jeweils eines Pumpmoduls (2) in der Reihenfolge abnehmender Emissionswellenlänge, bezogen auf die gleiche Betriebstemperatur, angeordnet sind,
daß jeweils das erste Laserdiodenarray (3.1) eines jeden Pumpmoduls (2) auf die Temperatur stabilisiert wird, bei welcher die Emissionswellenlänge weitestgehend der Absorptionsbande des laseraktiven Mediums entspricht,
und daß die Weglänge der jeweils von einem Laserdiodenarray (3) emittierten Strahlung durch den Festkörperlaserstab (1) und der erforderliche Absorptionsweg für die Strahlung, bestimmt durch die Emissionswellenlänge der Strahlung und die Dotierung des laseraktiven Mediums weitestgehend, aufeinander abgestimmt sind um eine erhöhte Effizienz zu erreichen.

2. Diodengepumpter Hochleistungsfestkörperlaser nach Anspruch 1, dadurch gekennzeichnet,
daß zur Temperaturstabilisierung der Laserdiodenarrays (3) jeweils eines Pumpmoduls (2) diese jeweils auf einem separaten Kühlkörper (4) aufgebracht sind, wobei der einzige thermischer Kontakt zwischen den Kühlkörpern (4) über ein durch die Kühlkörper (4) geführtes Kühlrohr (6) besteht, in welchem ein Kühlmedium in Richtung der mit abnehmender Wellenlänge angeordneten Laserdiodenarrays (3) strömt und das Kühlmedium beim Eintritt in das Kühlrohr (4) die Temperatur aufweist, bei welcher das in der Reihenfolge erste angeordnete Laserdiodenarray (z.B. 4.1) eine Emissionswellenlänge weitestgehend gleich der Absorptionsbande des laseraktiven Mediums aufweist.

3. Diodengepumpter Hochleistungsfestkörperlaser nach Anspruch 1 oder 2, dadurch gekennzeichnet,
daß die Koppeloptik (10) eine Zylinderlinse ist, die den Laserdiodenarrays (3) eines Pumpmoduls (2) so vorgeordnet ist, daß sich ihr Abstand zu den in Richtung mit abnehmender Wellenlänge angeordneten Laserdiodenarrays (3) verringert, so daß die Schnittweite (S) zunehmend kleiner ist und damit im wesentlichen der Bündelquerschnitt der Strahlung der einzelnen Laserdiodenarrays (3) verkleinert wird.

4. Diodengepumpter Hochleistungsfestkörperlaser nach Anspruch 1 oder 2, dadurch gekennzeichnet,
daß die Koppeloptik (10) eine Zylinderlinse ist, deren Brechzahl in Richtung der mit abnehmender Wellenlänge angeordneten Laserdiodenarrays (3) abnehmend ist.

5. Diodengepumpter Hochleistungsfestkörperlaser nach Anspruch 1 oder 2, dadurch gekennzeichnet,
daß die Koppeloptik (10) eine konische Linse ist, deren Durchmesser in Richtung der mit abnehmender Wellenlänge angeordneten Laserdiodenarrays (3) zunehmend ist.

6. Diodengepumpter Hochleistungsfestkörperlaser nach Anspruch 1 oder 2, dadurch gekennzeichnet,
daß der Festkörperlaserstab (1) ein konischer Stab ist, dessen Durchmesser in Richtung der mit abnehmender Wellenlänge angeordneten Laserdiodenarrays (3) zunehmend ist.

7. Diodengepumpter Hochleistungsfestkörperlaser nach Anspruch 1 oder 2, dadurch gekennzeichnet,
daß der Festkörperlaserstab (1) aus einem laseraktiven Medium besteht, dessen Dotierung in Richtung der mit abnehmender Wellenlänge angeordneten Laserdiodenarrays (3) zunehmend ist.

8. Diodengepumpter Hochleistungsfestkörperlaser nach einem der vorhergehenden Ansprüche, dadurch gekennzeichnet,
daß eine ungerade Anzahl von Pumpmodulen (2) in gleichmäßigen Abständen um den Festkörperlaserstab (1) angeordnet ist und der Festkörperlaserstab (1) von einem Kühlzylinder (7) mit einem Kühlmitteleingang (8) und einem Kühlmittelausgang (9) koaxial umschlossen wird, welche in den, den Laserdiodenarrays (3) gegenüberliegenden Bereichen, verspiegelt wird.

9. Diodengepumpter Hochleistungsfestkörperlaser nach Anspruch 2, dadurch gekennzeichnet,
daß das Kühlrohr (6) parallel zur Achse des Festkörperlaserstabes (1) angeordnet ist und seine Enden zwecks Justierung des Pumpmoduls (2) um die Kühlrohrachse als Lagerzapfen dienen.

10. Diodengepumpter Hochleistungsfestkörperlaser nach Anspruch 1, dadurch gekennzeichnet,
daß mindestens zwei Pumpmodule (2) vorhanden sind.

11. Diodengepumpter Hochleistungsfestkörperlaser nach den Ansprüchen 8 und 9 oder 9 und 10, dadurch gekennzeichnet,
daß die Kühlrohre (6) der Pumpmodule (2) einerseits untereinander mit dem Kühlmittel eingang (8) des Kühlzylinders (7) und einer Kühlmittelzuführung über eine erste Ausgleichskammer und andererseits untereinander mit dem Kühlmittelausgang (9) und einer Kühlmittelabführung über eine zweite Ausgleichskammer verbunden sind.

## Claims

1. A diode-pumped high-power solid-state laser comprising a solid-state laser rod (1), at least one pump module (2) disposed parallel to the axis of the laser rod (1) and comprising at least two temperature-stabilised laser-diode arrays (3), and an optical coupling system (10) disposed between each pump module (2) and the solid-state laser rod (1), characterised in that
the laser diode arrays (3) for each pump module (2) are disposed in order of decreasing emission wavelengths relative to the same operating temperature,
in that the first laser diode array (3.1) of each pump module (2) is stabilised at the temperature at which the emission wavelength most closely corresponds to the absorption bands of the laser-active medium,
and in that the length of travel of the radiation emitted through the solid-state laser rod (1) by each laser diode array (3) is substantially adapted to the absorption travel required for the radiation, depending on the emission wavelength of the radiation and the doping of the laser-active material, to obtain increased efficiency.

2. A diode-pumped high-power solid-state laser according to claim 1, characterised in that each pump module (2), in order to stabilise the temperature of the laser diode array (3) therein, is disposed on a separate heat dissipator (4), the only thermal contact between the heat dissipators (4) being via a cooling tube (6) which extends through the heat dissipators (4) and in which a cooling medium flows in the direction of the laser diode arrays (3) disposed in order of decreasing wavelength and the cooling medium, on entering the cooling tube (4), is at the temperature at which the laser diode array (e.g. 4.1) disposed first in the sequence has an emission wavelength substantially equal to the absorption bands of the laser-active material.

3. A diode-pumped high-power solid-state laser according to claim 1 or 2, characterised in that the optical coupling system (10) is a cylindrical lens which is so disposed in front of the laser diode array (3) of one pump module (2) that its distance from the laser diode array (3) disposed in the direction of decreasing wavelength decreases, so that the intercept length (S) becomes increasingly smaller, resulting substantially in a decrease in the cross-section of the beam from each laser diode array (3).

4. A diode-pumped high-power solid-state laser according to claim 1 or 2, characterised in that the optical coupling system (10) is a cylindrical lens whose refractive index decreases in the direction of the laser diode arrays (3) disposed in order of decreasing wavelength.

5. A diode-pumped high-power solid-state laser according to claim 1 or 2, characterised in that the optical coupling system (10) is a conical lens whose diameter increases in the direction of the laser diode arrays (3) disposed in order of decreasing wavelength.

6. A diode-pumped high-power solid-state laser according to claim 1 or 2, characterised in that the solid-state laser rod (1) is a conical rod whose diameter increases in the direction of the laser diode arrays (3) disposed in order of decreasing wavelength.

7. A diode-pumped high-power solid-state laser according to claim 1 or 2, characterised in that the solid-state laser rod (1) consists of a laser-active medium whose doping increases in the direction of the laser diode arrays (3) disposed in order of decreasing wavelength.

8. A diode-pumped high-power solid-state laser according to any of the preceding claims, characterised in that an odd number of pump modules (2) are disposed at uniform distances around the solid-state laser rod (1), and the rod (1) is coaxially surrounded by a cooling cylinder (7) comprising a coolant inlet (8) and a coolant outlet (9) and given a reflecting coating in the regions opposite the laser diode arrays (3).

9. A diode-pumped high-power solid-state laser according to claim 2, characterised in that the cooling tube (6) is disposed parallel to the axis of the solid-state laser rod (1) and its ends serve as trunnions for adjusting the pump module (2) around the cooling-tube axis.

10. A diode-pumped high-power solid-state laser according to claim 1, characterised in that at least two pump modules (2) are provided.

11. A diode-pumped high-power solid-state laser according to claims 8 and 9 or 9 and 10, characterised in that the cooling tubes (6) of the pump modules (2) are interconnected on the one hand via the coolant inlet (8) of the cooling cylinder (7) and a coolant supply through a first compensating chamber and on the other hand via the coolant outlet (9) and a coolant discharge through a second compensating chamber.

## Revendications

1. Laser à solide de haute puissance à pompage à diode comportant une barre de laser à solide (1), au moins un module de pompage (2) disposé parallèlement à l'axe de la barre de laser à solide (1), lequel module comprend au moins deux ensembles de diodes laser (3) à température stabilisée et pour chacun une optique de couplage (10) disposée entre le module de pompage (2) et la barre de laser à solide (1), caractérisé en ce que les ensembles de diodes laser (3) de chaque module de pompage (2) sont disposés dans l'ordre de la longueur d'onde d'émission décroissante, pour la même température de service, en ce que le premier ensemble de diodes laser (3.1) de chaque module de pompage (2) est stabilisé à la température à laquelle la longueur d'émission correspond pratiquement à la bande d'absorption du milieu actif, et en ce que la longueur du parcours du rayonnement émis par un ensemble de diodes laser (3) à travers la barre de laser à solide (1) et la distance d'absorption nécessaire pour le rayonnement, déterminée par la longueur d'onde d'émission du rayonnement et le dopage du milieu actif, sont largement accordées l'une à l'autre pour atteindre une efficacité accrue.

2. Laser à solide de haute puissance à pompage à diode selon la revendication 1, caractérisé en ce que pour la stabilisation de la température de l'ensemble de diodes laser (3) de chaque module de pompage (2) ceux-ci sont montés respectivement sur un corps de refroidissement (4) séparé, l'unique contact thermique entre les corps de refroidissement (4) se faisant par un tube de refroidissement (6) guidé à travers les corps de refroidissement (4) dans lequel s'écoule un fluide de refroidissement dans le sens des ensembles de diodes laser (3) disposés suivant la longueur d'onde décroissante, et le fluide de refroidissement entrant dans le tube de refroidissement (4) présente la température à laquelle le premier dans l'ordre des ensembles de diodes laser (par exemple 4.1) présente une longueur d'onde d'émission pratiquement égale à la bande d'absorption du milieu actif.

3. Laser à solide de haute puissance à pompage à diode selon la revendication 1 ou 2, caractérisé en ce que l'optique de couplage (10) est une lentille cylindrique, qui est disposée devant les ensembles de diodes laser (3) d'un module de pompage (2) de manière que sa distance par rapport aux ensembles de diodes laser (3), disposés dans le sens de la longueur d'onde décroissante, diminue, de sorte que la distance d'intersection (S) est de plus en plus petite et qu'ainsi pour l'essentiel la section du faisceau de rayons des divers ensembles de diodes laser (3) s'en trouve réduite.

4. Laser à solide de haute puissance à pompage à diode selon la revendication 1 ou 2, caractérisé en ce que l'optique de couplage (10) est une lentille cylindrique dont l'indice de réfraction diminue dans le sens des ensembles de diodes laser (3) disposés suivant la longueur d'onde décroissante.

5. Laser à solide de haute puissance à pompage à diode selon la revendication 1 ou , caractérisé en ce que l'optique de couplage (10) est une lentille conique dont le diamètre augmente dans le sens des ensembles de diodes laser disposés suivant la longueur d'onde décroissante.

6. Laser à solide de haute puissance à pompage à diode selon la revendication 1 ou 2, caractérisé en ce que la barre de laser à solide (1) est une barre conique dont le diamètre augmente dans le sens des ensembles de diodes laser disposés suivant la longueur d'onde décroissante.

7. Laser à solide de haute puissance à pompage à diode selon la revendication 1 ou 2, caractérisé en ce que la barre de laser à solide (1) est un fluide actif de laser, dont le dopage augmente dans le sens des ensembles de diodes laser disposés suivant la longueur d'onde décroissante.

8. Laser à solide de haute puissance à pompage à diode selon l'une des revendications précédentes, caractérisé en ce qu'un nombre impair de modules de pompage (2) est disposé à distances régulières autour de la barre de laser à solide (1) et en ce que la barre de laser à solide (1) est entourée coaxialement par un cylindre de refroidissement (7) avec une entrée de fluide de refroidissement (8) et une sortie de fluide de refroidissement (9), qui et réfléchi dans les zones faisant face aux ensembles de diodes laser (3).

9. Laser à solide de haute puissance à pompage à diode selon la revendication 2, caractérisé en ce que le tube de refroidissement (6) est parallèle à l'axe de la barre de laser à solide (1) et ses extrémités servent de tourillons en vue de l'ajustage du module de pompage (2) autour de l'axe du tube de refroidissement.

10. Laser à solide de haute puissance à pompage à diode selon la revendication 1, caractérisé en ce que sont prévus au moins deux modules de pompage (2).

11. Laser à solide de haute puissance à pompage à diode selon les revendications 8 et 9 ou 9 et 10, caractérisé en ce que les tubes de refroidissement (6) des modules de pompage (2) sont reliés d'une part entre eux à l'entrée de fluide de refroidissement (8) du cylindre de refroidissement (7) et à une arrivée de fluide de refroidissement, par une première chambre de compensation et sont reliés d'autre part entre eux à la sortie de fluide de refroidissement (9) et à un départ de fluide de refroidissement, par une deuxième chambre de compensation.
